Europäisches Patentamt

European Patent Office

Office européen des brevets

(11) Numéro de publication: 0 178 987
A1

(12) ## DEMANDE DE BREVET EUROPEEN

(21) Numéro de dépôt: 85401961.9

(22) Date de dépôt: 08.10.85

(51) Int. Cl.4: C30B 13/02 , C30B 13/26

(30) Priorité: 18.10.84 FR 8415967

(43) Date de publication de la demande:
23.04.86 Bulletin 86/17

(84) Etats contractants désignés:
DE GB IT

(71) Demandeur: COMMISSARIAT A L'ENERGIE ATOMI-
QUE Etablissement de Caractère Scientifique Technique et Industriel
31/33, rue de la Fédération
F-75015 Paris(FR)

(72) Inventeur: Fillot, Alain
Chemin des Ratz Saint Nazaire les Eymes
F-38330 Saint Ismier(FR)
Inventeur: Gallet, Jean
Le Babolin Miribel-Les-Echelles
F-38380 Saint Laurent du Pont(FR)
Inventeur: Paltrier, Sylvain
Route de Palluel Brandegaudière
F-38340 Voreppe(FR)
Inventeur: Schaub, Bernard
30, rue Gay Lussac
F-38000 Grenoble(FR)

(74) Mandataire: Mongrédien, André et al
c/o BREVATOME 25, rue de Ponthieu
F-75008 Paris(FR)

(54) Procédé de fabrication de cristaux de composés au moins ternaires par transfert d'une zone de solvant.

(57) L'invention a pour objet un procédé de fabrication de cristaux de composés au moins ternaires par transfert d'une zone de solvant.

Selon ce procédé, on applique un champ magnétique continu à la zone de solvant (9) et on maintient ce champ magnétique dans la zone de solvant lors de son trasfert. Ce procédé s'applique en particulier à la fabrication de cristaux de $Cd_xHg_{1-x}Te$ et $Cd_xHg_{1-x}Te_ySe_{1-y}$ et il permet d'obtenir une homogénéité radiale de composition.

FIG. 2

EP 0 178 987 A1

# PROCEDE DE FABRICATION DE CRISTAUX DE COMPOSES AU MOINS TERNAIRES PAR TRANSFERT D'UNE ZONE DE SOLVANT

La présente invention concerne la fabrication de cristaux de composés au moins ternaires par la méthode dite de "transfert d'une zone de solvant".

Ce procédé s'applique en particulier à la fabrication des cristaux de composés semi-conducteurs ternaires ou quaternaires tels que les composés de formule $Cd_xHg_{1-x}Te_1$, et de formule $Cd_x Hg_{1-x}Te_ySe_{1-y}$ dans lesquelles x et y sont compris entre 0 et 0,5. De tels composés présentent une largeur de bande interdite qui varie continûment avec les fractions atomiques x et y, ce qui autorise ainsi la fabrication de photodétecteurs infrarouges fonctionnant à toute longueur d'onde supérieure à 0,8 µm.

L'utilisation de la méthode dite de "transfert d'une zone de solvant" permet d'élaborer de tels composés à une température inférieure à leur température de fusion et d'obtenir ainsi des matériaux très purs et de bonne qualité cristalline. Par ailleurs, dans le cas particulier des composés semi-conducteurs CdHgTe et CdHgTeSe, l'utilisation d'un solvant permet de s'affranchir des difficultés liées au fait que le mercure présente une pression de vapeur élevée à la température de fusion de ces composés.

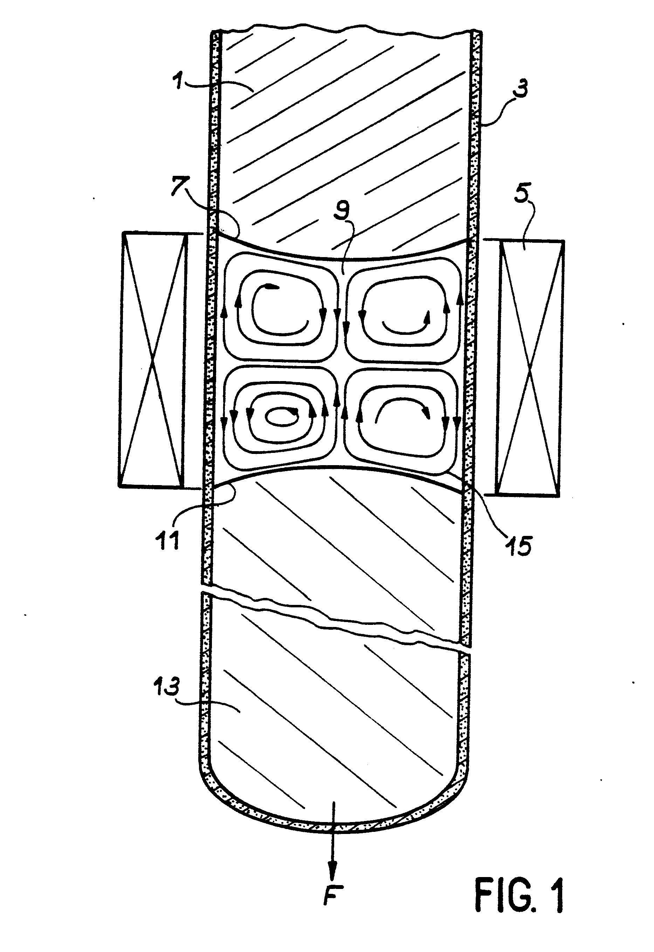

Le principe général de la méthode dite de "transfert d'une zone de solvant" appliqué à la croissance de cristaux de composés semi-conducteurs ternaires de type II-VI a été décrit par G.A.Wolff et coll. en 1968 dans Transaction of the Metallurgical Society of A.I.M.E., vol.242, mars 1968, p.436-441. Comme illustré sur la figure 1 qui représente schématiquement la croissance d'un cristal par transfert d'une zone de solvant, cette méthode consiste à introduire un lingot polycristallin 1 du composé semi-conducteur à préparer ou plusieurs lingots formés des constituants du composé semi-conducteur à préparer dans une nacelle cylindrique 3 en position verticale, après avoir disposé à l'extrémité inférieure de cette nacelle une zone de solvant. Cette nacelle est disposée dans un four annulaire 5 et elle peut se déplacer en suivant le trajet de la flèche F à travers l'espace annulaire défini par le four 5 de sorte que, après fusion préalable de la zone de solvant, on provoque lors du déplacement de la nacelle, une dissolution du solide polycristallin et sa recristallisation sous la forme de monocristal. En cours de croissance, on distingue donc successivement la zone 1 où se trouve le lingot polycristallin du composé semi-conducteur, l'interface de dissolution 7, la zone de solvant 9, l'interface de cristallisation 11, et la zone 13 du monocristal élaboré.

L'utilisation de cette méthode de "transfert d'une zone de solvant" pour la réalisation de composés semi-conducteurs ternaires ou quaternaires du type II-VI est également décrite dans les brevets français FR-A-82/20053 déposé le 30/11/82 au nom du Commissariat à l'Energie Atomique et FR-A-2295792 déposé le 24/12/74 au nom du C.E.A.

Bien que l'emploi de cette technique pour la fabrication de composés semi-conducteurs ternaires ou quaternaires CdHgTe ou CdHgTeSe permette d'obtenir des résultats satisfaisants, elle présente toutefois l'inconvénient de conduire à des fluctuations radiales de composition du semi-conducteur, qui sont difficilement acceptables dans le cadre de certaines applications. En effet, les cristaux obtenus qui sont généralement cylindriques présentent des variations radiales de la composition conduisant à une inhomogénéité intolérable des caractéristiques de dispositifs photodétecteurs réalisés à partir de tels cristaux.

Pour surmonter cet inconvénient, on peut envisager de découper les cristaux selon des plans perpendiculaires à l'axe ou de réaliser des cristaux de faible diamètre afin de limiter ce phénomène d'inhomogénéité, mais ces solutions sont peu satisfaisantes.

Pour résoudre ce problème d'inhomogénéité, on a aussi envisagé d'ajouter un cylindre de graphite au fond de la nacelle afin de modifier favorablement la répartition des flux thermiques à l'interface de croissance, comme cela est décrit dans I.E.E. Transactions of Electron Devices, vol.ED 27, n°1, janvier 1981, p.150 à 154, par Makoto Itoh et coll. Cependant, une telle configuration conduit à aplatir l'interface de croissance, qui ne peut plus être adaptée de ce fait à tout type de zone et de diamètre.

La présente invention a précisément pour objet un procédé de fabrication de cristaux de composés au moins ternaires par la méthode dite de "transfert d'une zone de solvant", qui pallie cet inconvénient et permet l'obtention de cristaux ne présentant pas de dispersion radiale de composition et ce, quels que soient le diamètre du cristal, la composition et la nature de la zone de solvant, le mode de préparation du polycristal source et la température d'élaboration.

Le procédé, selon l'invention, de fabrication de cristaux de composés au moins ternaires par transfert d'une zone de solvant, se caractérise en ce que l'on applique un champ magnétique continu à la zone de solvant et en ce que l'on maintient ce champ magnétique continu dans la zone de solvant lors de son transfert.

L'application, selon l'invention, d'un champ magnétique continu dans la zone liquide de solvant permet de supprimer les mouvements de convection thermique établis dans cette zone et d'éviter qu'il ne se produise un appauvrissement du solvant en certains solutés à l'interface solide-liquide de cristallisation.

En effet, comme représenté sur la figure 1, lorsqu'une zone liquide telle que la zone de solvant 9 est disposée dans un gradient thermique, elle est le siège de mouvements tourbillonnaires stables 15 qui sont d'autant plus importants que les gradients thermiques appliqués sont forts, ce qui est le cas dans le procédé de transfert d'une zone de solvant. Par ailleurs, dans le cas de la cristallisation de composés au moins ternaires, il se produit généralement un appauvrissement du solvant en solutés à l'interface solide-liquide 11 de cristallisation, et cet appauvrissement est généralement plus important pour l'un des solutés ; ainsi, lors de la cristallisation de CdHgTe à partir d'une zone de solvant riche en tellure, on peut observer à l'interface de cristallisation solide-liquide, un appauvrissement plus important du solvant en cadmium qu'en mercure. En raison de ces deux phénomènes (courants de convection thermique et appauvrissement plus important en certains solutés à l'interface de cristallisation solide-liquide), il se produit une inhomogénéité de composition du liquide au voisinage de l'interface 11 de cristallisation et, de ce fait, le solide qui cristallise ne peut présenter une homogénéité de composition satisfaisante. En supprimant, grâce à l'application du champ magnétique continu, les mouvements de convection du liquide, on maintient un état de stagnation du liquide et on obtient une libre diffusion dans tout le solvant des espèces solutées, ce qui permet d'obtenir une composition homogène du liquide et donc du solide cristallisé.

On avait déjà envisagé d'utiliser un champ magnétique pour supprimer les courants de convection dans des procédés de fabrication de monocristaux par fusion de zone ou par tirage à partir d'un bain fondu, par exemple dans la méthode de Czochralski, comme cela est décrit dans les documents : brevet allemand DE-A-2212310 ; Journal of crystal growth, vol. 62, n°3, août 1983, p. 523-531 ; K.M. Kim "Suppression of thermal convection by transverse magnetic field" J. Electrochem. Soc., VOL.129, n°2 (février 1982), p.427-429 et H.C. Gatos "Czochralski-type crystal growth in transverse magnetic fields" J. Mater. Sci. vol.5 p.822 à 824 (1970).

Cependant, dans ces cas de réalisation de monocristaux à partir d'un bain fondu, l'application d'un champ magnétique n'a pas pour but l'obtention d'une composition homogène du monocristal qui par ailleurs n'est pas constitué par un composé au moins ternaire. En effet, le monocristal est produit à partir d'un bain entièrement fondu nécessairement homogène et de même composition que le cristal à obtenir et les problèmes liés à la dissolution des constituants d'un composé ternaire à partir d'un lingot polycristallin et à la diffusion de ces constituants dans un solvant ne se posent pas.

Dans les procédés de fusion de zone ou de tirage à partir d'un bain fondu, la suppression des courants de convection permet de supprimer les fluctuations thermiques du bain et de ce fait les instabilités de croissance ; ceci autorise une augmentation du gradient thermique qui reste cependant relativement faible, et est sans comparaison avec les forts gradients thermiques utilisés dans le procédé de l'invention.

Ainsi, les conditions de croissance dans ces procédés et dans le procédé de transfert d'une zone de solvant sont très différentes et l'on ne pouvait prévoir que dans la méthode de croissance par transfert d'une zone de solvant, la suppression des courants de convection permettrait d'obtenir dans de bonnes conditions des cristaux présentant une homogénéité radiale de composition. En effet, du point de vue de la répartition des flux thermiques, qui est principalement régie par la convection en raison des forts gradients thermiques longitudinaux, (sensiblement 100°C/cm) spécifiques à la technique de transfert d'une zone de solvant, on pouvait craindre que le passage d'un régime d'échanges thermiques convectifs à un régime purement conductif modifie la géométrie des isothermes et en conséquence, la forme de l'interface de croissance, qui aurait pu ainsi devenir inapte à une monocristallisation satisfaisante.

Par ailleurs, du point de vue des échanges de matière, la technique de transfert d'une zone de solvant fait appel à un solvant qui doit être constamment réalimenté. L'absence de renouvellement par convection de la zone de la phase liquide à l'interface de dissolution entraîne de ce fait une diminution de la cinétique de dissolution du lingot source, qui aurait pu imposer un ralentissement considérable de la vitesse de croissance.

Enfin, l'alimentation en solutés de l'interface de cristallisation ne s'effectue plus désormais que par diffusion dans le solvant et la vitesse de croissance n'est alors régie que par la cinétique de diffusion des solutés dans le liquide, ce qui aurait pu imposer une vitesse de croissance rédhibitoirement lente.

De plus, Gatos et al indiquent que dans le procédé Czochralski, la suppression des courants de convection a un effet défavorable sur l'obtention d'une distribution homogène des impuretés.

Aussi, on ne pouvait supposer que dans la méthode de croissance par transfert d'une zone de solvant, la suppression des courants de convection aurait au contraire un effet favorable sur l'homogénéité de composition des cristaux.

Dans le procédé de l'invention, le champ magnétique continu peut être produit par tout moyen approprié, par exemple par un aimant permanent ou par un électro-aimant. L'orientation du vecteur champ magnétique par rapport à la direction de déplacement de la zone de solvant n'a pas non plus réellement d'importance sur le résultat obtenu. Toutefois, il est plus commode d'appliquer le champ magnétique perpendiculairement à la direction selon laquelle on transfère la zone de solvant.

La valeur de l'induction magnétique du champ est choisie en fonction des dimensions du cristal à obtenir qui correspondent sensiblement au diamètre et à la hauteur de la nacelle, de la composition du cristal et de la température de la zone de solvant. En général, la valeur de l'induction magnetétique doit être supérieure à une valeur minimale qui dépend de ces différents paramètres. Il n'est pas nécessaire que le champ soit uniforme dans toute la zone de solvant, car il suffit que la valeur minimale requise de l'induction magnétique soit atteinte en tous les points de cette zone de solvant.

Dans le cas de composés semi-conducteurs ternaires répondant à la formule $Cd_xHg_{1-x}Te_1$, avec x compris entre 0 et 0,5, on peut utiliser un champ magnétique ayant une induction d'au moins 800 Gauss (0,08 Tesla).

D'autres caractéristiques et avantages de l'invention apparaîtront mieux à la lecture de l'exemple suivant donné bien entendu à titre illustratif et non limitatif en référence au dessin annexé sur lequel :

- la figure 1, déjà décrite, illustre la méthode de croissance par transfert d'une zone de solvant,

- la figure 2 illustre la fabrication de cristaux de composés semi-conducteurs au moins ternaires par mise en oeuvre du procédé de l'invention,

- les figures 3 et 4 illustrent les variations de composition radiale du cristal obtenu avec application d'un champ magnétique (figure 3) et en l'absence de champ magnétique (figure 4).

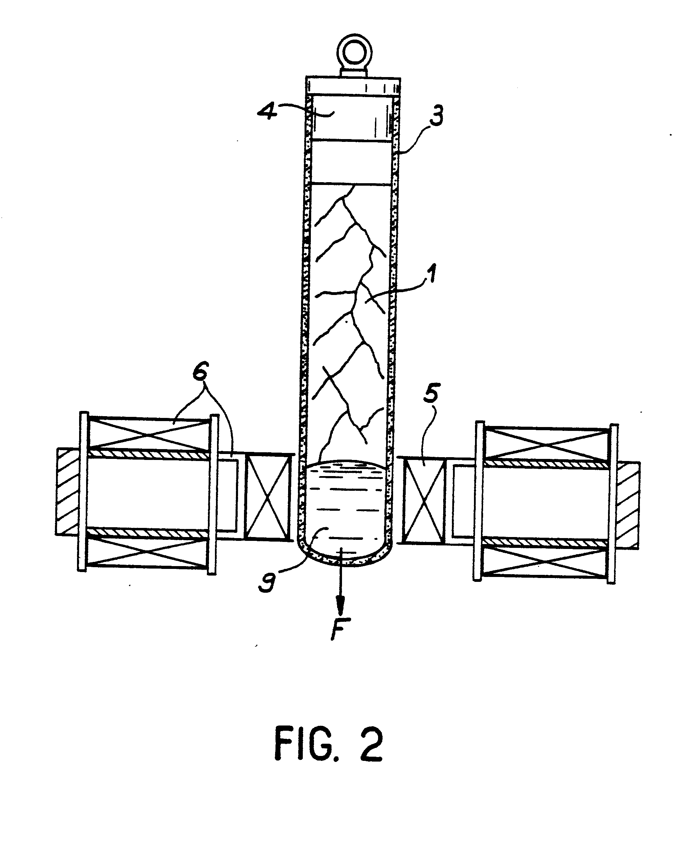

Cet exemple illustre la fabrication d'un cristal de composé semi-conducteur ternaire de composition $Cd_{0,11}Hg_{0,12}Te_{0,1}$, dans le dispositif représenté schématiquement sur la figure 2.

Sur cette figure, on a repris les mêmes références que celles de la figure 1 pour les éléments qui sont communs. Ainsi, on retrouve sur la figure 2 le four annulaire 5 à l'intérieur duquel peut se déplacer en suivant le trajet de la flèche F, la nacelle 3 à l'extrémité inférieure de laquelle est disposée une zone de solvant 9 surmontée d'un barreau polycristallin 1 dont la composition correspond à la formule $Cd_{0,11}Hg_{0,12}Te_{0,1}$. Le four annulaire 5 est entouré d'un électro-aimant 6 qui permet d'appliquer un champ magnétique continu transversal dans la zone de la nacelle 9 située en regard du four annulaire 5. Dans l'exemple décrit, ci-dessous, la nacelle 3 présente un diamètre intérieur de 24 mm. On dispose tout d'abord dans cette nacelle la zone de solvant 9 qui est obtenue par fusion et dissolution à 580°C de 10 g de tellure et 24,5 g de HgTe sous atmosphère d'hydrogène. Après refroidissement de cette zone, on dispose au-dessus un barreau polycristallin 1 de 24 mm de diamètre et de 90 mm de longueur répondant à

la formule $Cd_{0,11}Hg_{0,89}Te_{0,5}$ qui a été obtenu par fusion et trempe, selon un procédé adapté, d'un mélange adéquat des trois éléments. On scelle alors la nacelle 3 sous vide au moyen du bouchon de silice 4 et on la dispose dans le four annulaire 5 qui est porté à 650°C. On applique alors un champ magnétique continu ayant une induction de 1000 gauss ± 10% (0,1T) en utilisant deux solénoïdes de 2500 spires chacun bobinés sur un circuit magnétique fermé présentant un entrefer de 150 mm.

Après fusion de la zone de solvant et application du champ magnétique continu, on déplace la nacelle 3 vers le bas à une vitesse de 0,3 mm/h tout en la maintenant en rotation, ce qui provoque le déplacement de la zone de solvant et la croissance d'un monocristal du semi-conducteur ternaire de formule $Cd_{0,11}Hg_{0,89}Te_{0,5}$.

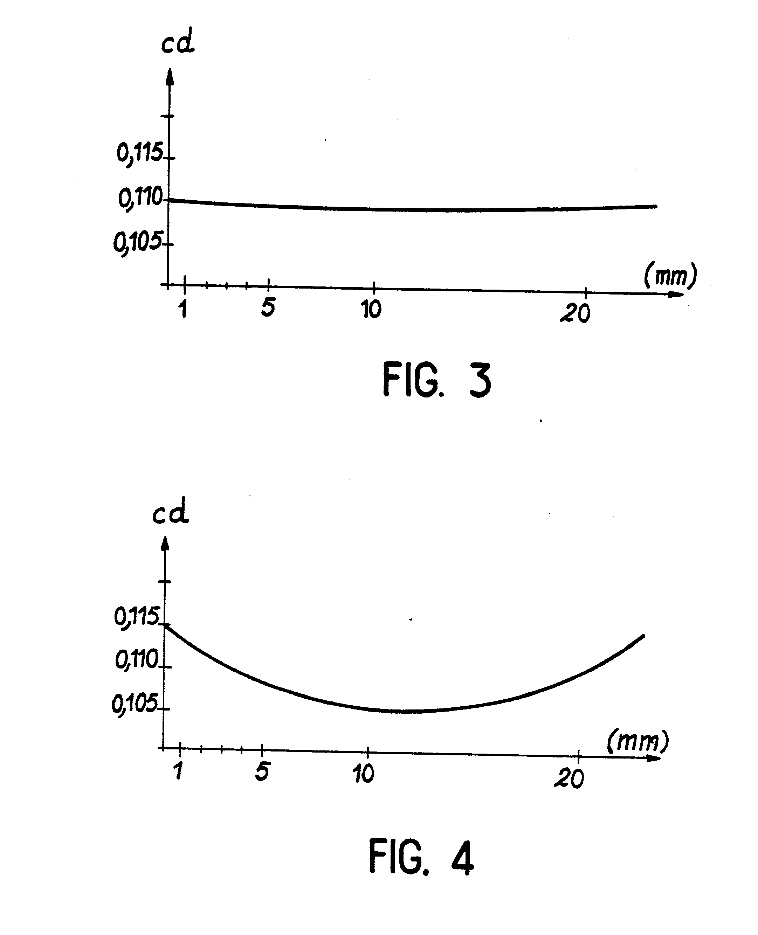

En fin d'opération, on détermine le profil radial de composition du monocristal obtenu. Les résultats sont donnés sur la figure 3 qui représente la teneur en cadmium du monocristal en fonction de la distance radiale. Au vu de cette figure, on constate que la teneur en cadmium est de 0,11 et reste stable et homogène dans toute la section du cristal.

A titre comparatif, on a représenté sur la figure 4, le profil radial de composition obtenu en préparant un monocristal de $Cd_{0,11}Hg_{0,89}Te_{0,5}$ dans les mêmes conditions mais en l'absence de champ magnétique. Au vu de cette figure, on constate que la composition du cristal varie de façon importante en fonction de la distance radiale.

Ainsi, l'application d'un champ magnétique, conformément au procédé de l'invention, permet d'obtenir un résultat très amélioré par rapport à ceux obtenus précédemment.

## Revendications

1. Procédé de fabrication de cristaux de composés au moins ternaires par transfert d'une zone de solvant, caractérisé en ce que l'on applique un champ magnétique continu à la zone de solvant (9) et en ce que l'on maintient ce champ magnétique continu dans la zone de solvant lors de son transfert.

2. Procédé selon la revendication 1, caractérisé en ce que le champ magnétique est appliqué perpendiculairement à la direction selon laquelle on transfère la zone de solvant.

3. Procédé selon l'une quelconque des revendications 1 et 2, caractérisé en ce que le composé est un semi-conducteur ternaire ou quaternaire.

4. Procédé selon la revendication 3, caractérisé en ce que le composé semi-conducteur ternaire répond la formule $Cd_xHg_{1-x}Te_{0,5}$ avec x compris entre 0 et 0,5.

5. Procédè selon la revendication 3, caractérisé en ce que le composé semi-conducteur quaternaire répond à la formule $Cd_xHg_{1-x}Te_ySe_{1-y}$ avec x et y compris entre 0 et 0,5.

6. Procédé selon la revendication 4, caractérisé en ce que le champ magnétique est d'au moins 800 Gauss (0,08 Tesla).

FIG. 1

FIG. 2

**FIG. 3**

**FIG. 4**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| D,Y | FR-A-2 295 792 (COMMISSARIAT A L'ENERGIE ATOMIQUE) <br> * Figure 1; revendications * <br> --- | 1,3 | C 30 B 13/02 <br> C 30 B 13/26 |
| D,Y | DE-A-2 212 310 (SIEMENS) <br> * Page 3, lignes 11-26 * <br> --- | 1,3 | |
| D,A | JOURNAL OF CRYSTAL GROWTH, vol. 62, no. 3, août 1983, pages 523-531, North Holland Publishing Co., Amsterdam, NL; H. KIMURA et al.: "Magnetic field effects on float-zone Si crystal growth" <br> ----- | | |

**DOMAINES TECHNIQUES RECHERCHES (Int. Cl.4)**

C 30 B

Le présent rapport de recherche a été établi pour toutes les revendications

| Lieu de la recherche | Date d'achèvement de la recherche | Examinateur |
|---|---|---|
| LA HAYE | 06-11-1985 | STEIN K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82